# EUROPÄISCHE PATENTSCHRIFT

(11) **EP 3 538 319 B1**
(45) Veröffentlichungstag und Bekanntmachung des Hinweises auf die Patenterteilung: **02.12.2020**
(21) Anmeldenummer: 17791670.7
(22) Anmeldetag: 27.10.2017
(51) Int. Cl.: B24B 53/017

(54) **VERFAHREN ZUM BEIDSEITIGEN POLIEREN EINER HALBLEITERSCHEIBE**
METHOD FOR TWO-SIDED POLISHING OF A SEMICONDUCTOR WAFER
PROCÉDÉ DE POLISSAGE BILATÉRAL D'UNE PLAQUETTE DE SEMI-CONDUCTEUR

(30) Priorität: 10.11.2016 DE 102016222063
(43) Veröffentlichungstag der Anmeldung: 18.09.2019
(73) Patentinhaber: Siltronic AG, 81737 München (DE)
(72) Erfinder: DUTSCHKE, Vladimir, 09514 Lengefeld (DE)
(74) Vertreter: Killinger, Andreas
(86) Internationale Anmeldenummer: PCT/EP2017/077571
(87) Internationale Veröffentlichungsnummer: WO 2018/086912

(56) Entgegenhaltungen:
- EP-A1- 1 775 068
- US-A1- 2014 206 261

## Beschreibung

Gegenstand der Erfindung ist ein Verfahren zum beidseitigen Polieren einer Halbleiterscheibe.

Das Doppelseiten-Polieren (DSP) ist ein Verfahren aus der Gruppe der chemomechanischen Bearbeitungsschritte. Eine DSP-Bearbeitung von Halbleiterscheiben ist beispielsweise beschrieben in US 2003/054650 A1 und eine dafür geeignete Vorrichtung in DE 100 07 390 A1. Die DSP umfasst ein chemisches Ätzen mittels einer Lauge und ein mechanisches Erodieren mittels im wässrigen Medium dispergierten losen Korns, welches durch ein Poliertuch, das keine in Kontakt mit der Halbleiterscheibe gelangenden Hartstoffe enthält, in Kontakt mit der Halbleiterscheibe gebracht wird und so unter Druck und Relativbewegung einen Materialabtrag von der Halbleiterscheibe bewirkt.

Beim DSP liegen die Arbeitsschichten in Form von Poliertüchern vor, und diese sind klebend, magnetisch, formschlüssig (beispielsweise mittels Klettverschluss) oder mittels Vakuum auf den Arbeitsscheiben, welche beim DSP auch als sog. Polierteller bezeichnet werden, befestigt. Beide Polierteller einer DSP-Anlage sind mit Poliertüchern beklebt. Um eine hohe Qualität der Bearbeitung durch DSP zu gewährleisten, sollten beide Poliertücher blasenfrei aufgeklebt sein. Dabei ist es wichtig, dass das Poliertuch über den gesamten Polierteller gleichmäßig stark haftet. Um die notwendige Haftung von Kleber zu erreichen, werden die Polierteller nach dem Aufkleben von Poliertüchern für mehrere Stunden unter Druck zusammengefahren. Dieser Prozess wird auch Tuchpressen genannt. Durch das Pressen verfließt der Kleber und haftet besser. Entsprechende Verfahren zum Tuchpressen sind beispielsweise aus EP 1 775 068 A1 und aus US 2008/0248728 A1 bekannt.

Poliertücher können aus einem thermoplastischen oder hitze-härtbaren Polymer bestehen.

Als Material für geschäumte Poliertücher (foamed pads) kommt eine Vielzahl an Werkstoffen in Betracht, z.B. Polyurethane, Polycarbonat, Polyamid, Polyacrylat, Polyester usw. Ein aus einem Polymer hergestelltes Poliertuch wird beispielsweise in US 2008/0102741 A1 offenbart.

Poliertücher können aber auch aus verschäumten Platten oder Filz- oder Fasersubstraten, die mit Polymeren imprägniert sind, bestehen (Vliesstoff-Tuch, non-woven pad). Ein solches Tuch ist beispielsweise in US 5,510,175 A beschrieben.

Die deutsche Offenlegungsschrift DE 10 2008 056 276 A1 lehrt ein Verfahren zur Regelung des Arbeitsspaltes einer Doppelseitenpoliermaschine. Dieser Arbeitsspalt, in dem sich das zu polierende Substrat befindet, wird durch eine obere und eine untere, mit jeweils einem Poliertuch (Arbeitsfläche) belegte Arbeitsscheibe gebildet. Durch eine Verstelleinrichtung kann mindestens eine Arbeitsscheibe verformt werden, so dass sich die Form des Arbeitsspaltes verändert und die Arbeitsflächen eine größtmögliche Parallelität besitzen. Durch die Regelung der Arbeitsspaltgeometrie soll ein möglichst gleichmäßiger Materialabtrag gewährleistet werden.

Aus US 2014/0206261 A1, die den Oberbegriff des Anspruchs 1 offenbart, ist ein Verfahren zur gleichzeitig beidseitigen Politur mindestens einer Scheibe aus Halbleitermaterial bekannt, bei dem harte, wenig kompressible Poliertücher zum Einsatz kommen, wobei eine spezielle Form des Arbeitsspaltes durch geeignete Dickenprofile der Poliertücher realisiert wird. Dieses Verfahren hat einen positiven Effekt bzgl. der Kante der polierten Halbleiterscheibe. Bei weichen und kompressiblen Poliertüchern sinkt die Scheibe nämlich etwas in die Arbeitsfläche des Poliertuches ein. Dadurch wirken im Randbereich der Scheibe höhere Kräfte auf die Scheibe ein als in anderen Bereichen der Scheibe, so dass die Kante durch einen erhöhten Materialabtag während der Politur verrundet.

Aus diesem Grund ist die Verwendung harter und wenig kompressibler Poliertücher von Vorteil. Um die harten und wenig kompressiblen Poliertücher absolut gleichmäßig, insbesondere ohne Luftbläschen oder Falten auf die Polierteller kleben zu können, können die Poliertücher auf ihren Rückseiten maschinell aufgebrachte Klebefilme aufweisen.

Beim Aufkleben der Poliertücher kann es gemäß US 2014/0206261 A1 von Vorteil sein, die Polierteller zu erwärmen, da sich durch die Erwärmung der Polierteller die Viskosität des Klebefilms bei gleichzeitiger Verbesserung der Haftbarkeit des Klebefilms verringert. Anschließend erfolgt die Abkühlung des mit dem Poliertuch belegten Poliertellers von der für das Aufkleben eingestellten Temperatur auf die gewünschte Prozesstemperatur über einen Zeitraum von mindestens 3 Stunden, wobei während des gesamten Abkühlvorganges das Poliertuch mit einem Druck von mindestens 10 000 Pa gegen den jeweils gegenüberliegenden Polierteller gedrückt wird.

Bei der Verwendung von harten, wenig kompressiblen Poliertüchern besteht allerdings das Problem, dass nach dem herkömmlichen Tuchpressen oftmals keine ausreichende Haftung der Poliertücher an den Poliertellern erzielt wird. Dies hängt damit zusammen, dass zwischen dem oberen und unteren Polierteller ein Polierspalt, der sich aus dem jeweiligen Abstand zwischen dem oberen und unteren Poliertuch ergibt, von bis zu 300 µm besteht. Die unzureichende Haftung der Poliertücher macht sich ohne Gegenmaßnahmen auch bei der Qualität der polierten Halbleiterscheiben bemerkbar.

In JP 2004140215 A1 ist offenbart, ein Poliertuch zu verwenden, das aus einem weichen und einem harten Tuch besteht. Die beiden Tücher können durch ein doppelseitiges Klebeband aneinander befestigt werden. Beim harten Tuch, mit dem die Halbleiterscheibe poliert wird, kann es sich um ein Tuch aus geschäumtem PU handeln. Das weiche Tuch dient als Dämpfung zwischen Polierteller und hartem Tuch. Auch hier besteht aber die Problematik, dass im Randbereich der Scheibe höhere Kräfte auf die Scheibe einwirken als in anderen Bereichen der Scheibe.

Aus der beschriebenen Problematik ergab sich die Aufgabenstellung der Erfindung.

Die Aufgabe der Erfindung wird gelöst durch das in Anspruch 1 beschriebene Verfahren zum beidseitigen Polieren einer Halbleiterscheibe.

Die Erfindung sieht vor, beim Tuchpressen eine Tuchzwischenlage zwischen oberem und unterem Poliertuch vorzusehen. Das obere und das untere Poliertuch sind hart und wenig kompressibel. Das als Zwischenlage verwendete Tuch ist kompressibler als die Poliertücher.

Die Kompressibilität eines Materials beschreibt, welche allseitige Druckänderung nötig ist, um eine bestimmte Volumenänderung hervorzurufen. Die Bestimmung der Kompressibilität erfolgt analog zur JIS L-1096 (Testing Methods for Woven Fabrics).

Das als Zwischenlage verwendete Tuch kommt nur beim Tuchpressen zum Einsatz. Nach dem Tuchpressen wird es aus der Polieranlage entfernt.

Als Poliertücher mit einer hohen Tuchhärte und einer geringen Tuchkompressibilität eignen sich sowohl geschäumte Poliertücher (foamed pads) als auch Poliertücher mit einer Faserstruktur (non-woven pads).

In einer Ausführungsform werden Poliertücher mit einer Härte von 80 bis 100° nach Shore A (DIN EN ISO 868) bei Raumtemperatur (23 °C ± 2 °C) verwendet.

Bevorzugt ist die Verwendung von Poliertüchern, die eine geringe oder sehr geringe Kompressibilität aufweisen.

Bevorzugt beträgt die Kompressibilität des Poliertuches weniger als 2,5%. Besonders bevorzugt beträgt die Kompressibilität des Poliertuches weniger als 2,2%. Ganz besonders bevorzugt beträgt die Kompressibilität des Poliertuches weniger als 2,0%. Die genannten Kompressibiltäten sind bei Raumtemperatur (23 °C ± 2 °C) zu ermitteln.

In einer Ausführungsform bestehen die Poliertücher bzw. deren Arbeitsflächen aus einem thermoplastischen oder hitze-härtbaren Polymer und weisen eine poröse Matrix auf (foamed pad).

Als Materialien für die Poliertücher kommen eine Vielzahl an Werkstoffen in Betracht, z.B. Polyurethane, Polycarbonat, Polyamid, Polyacrylat, Polyester usw.

In einer Ausführungsform bestehen die Poliertücher bzw. deren Arbeitsflächen aus festem mikro-porösen Polyurethan.

In einer anderen Ausführungsform bestehen die Poliertücher aus verschäumten Platten oder Filz- oder Fasersubstraten, die mit Polymeren imprägniert sind (Vliesstoff-Tuch, non-woven pad).

Die Dicke der Poliertücher kann 0,7 bis 1,5 mm betragen. In einer Ausführungsform beträgt die Dicke der Poliertücher 0,7 bis 1,3 mm, ganz besonders bevorzugt 0,75 bis 1,1 mm.

Im Rahmen der Erfindung hat sich gezeigt, dass insbesondere bei harten geschäumten Poliertüchern nur dann eine ausreichende Haftung an den Poliertellern sichergestellt werden kann, wenn beim Tuchpressen eine kompressible Zwischenlage zwischen den beiden zu pressenden Tüchern positioniert wird.

In einer Ausführungsform besteht das als Zwischenlage verwendete Tuch aus Filz oder einem Fasersubstrat, also aus einer nicht-gewebten Textilie.

Der Filz kann aus Chemiefasern oder natürlichen Fasern pflanzlichen oder tierischen Ursprungs erzeugt sein.

In einer Ausführungsform handelt es sich um Filz, hergestellt aus PU-Elastomer-Fasern.

Die Dicke der Zwischenlage kann 1,0 bis 3,0 mm betragen. In einer Ausführungsform beträgt die Dicke der Zwischenlage 1,5 bis 2,6 mm.

In einer Ausführungsform beträgt die Kompressibilität das als Zwischenlage verwendeten Tuchs 3-10%. Ganz besonders bevorzugt ist eine Kompressibilität des als Zwischenlage verwendeten Tuchs von 3,2-7,6%. Die genannten Kompressibiltäten sind bei Raumtemperatur (23 °C ± 2 °C) zu ermitteln.

Wenn als Zwischenlage dagegen Tücher mit einer Kompressibilität von kleiner als 3% oder mehr als 10% verwendet werden, wird in der Regel keine gleichmäßige Haftung der Poliertücher auf den Poliertellern erreicht.

In einer bevorzugten Ausführungsform umfasst das als Zwischenlage verwendete Tuch zwei Tuchlagen, die zusammengeklebt sind. Die Dicke einer Tuchlage beträgt nach einer bevorzugten Ausführungsform 0,7 bis 1,3 mm.

Zur Befestigung der beiden Tuchlagen eignet sich beispielsweise eine doppelseitige Klebefolie.

Durch die Verwendung einer solchen Zwischenlage beim Tuchpressen werden lokale Unebenheiten kompensiert und eine gleichmäßige Haftung über den ganzen Polierteller erreicht.

Vor dem Tuchpressvorgang werden die Poliertücher auf den jeweiligen Polierteller der Poliermaschine geklebt.

Dazu haben die Poliertücher in einer Ausführungsform des Verfahrens jeweils einen Klebefilm auf ihrer Rückseite. Beispielsweise eignen sich handelsübliche doppelseitige Klebefolien, die auf die Rückseite der Poliertücher aufgebracht werden.

In einer weiteren Ausführungsform werden die Polierteller vor dem Aufkleben der Poliertücher erwärmt. Beispielsweise können die Polierteller auf eine Temperatur von 40 - 50°C erwärmt werden. Dadurch verringert sich die Viskosität des Klebefilms bei gleichzeitiger Verbesserung seiner Haftbarkeit.

Nach dem Aufkleben der Poliertücher werden die Polierteller gegebenenfalls abgekühlt. In einer Ausführungsform werden die Polierteller auf die gewünschte Poliertemperatur abgekühlt, die in der Regel zwischen 10 und 50°C liegt.

Das Erwärmen und das Abkühlen der Polierteller vor und nach dem Aufkleben der Poliertücher erfolgt vorzugsweise mittels einer internen Temperatursteuerung der Polierteller.

In einer bevorzugten Ausführungsform erfolgt das Abkühlen der Polierteller über einen Zeitraum von einer bis zu mehreren Stunden.
In einer weiteren Ausführungsform erfolgt das Abkühlen der Polierteller während des Tuchpressens, der nachfolgend näher beschrieben wird.

In einer Ausführungsform erfolgt der Pressvorgang, bei dem die beiden wenig kompressiblen Poliertücher mit dem zwischen ihnen befindlichen kompressibleren Tuch für einen bestimmten Zeitraum aneinander gepresst werden.

Vorzugweise erfolgt das Tuchpressen bei einem Druck von mindestens 11 000 Pa.

In einer Ausführungsform erfolgt der Pressvorgang für die Dauer von einer oder mehreren Stunden.

Der Pressvorgang erfolgt vorzugweise bei der vom Hersteller der Poliertücher empfohlenen Aufklebetemperatur.

In einer Ausführungsform erfolgt der Pressvorgang bei Raumtemperatur.

Im Stand der Technik war bislang beim Aneinanderpressen der Poliertücher keine Zwischenlage zwischen den Poliertüchern vorgesehen. Die Poliertücher wurden auf die Polierteller geklebt und anschließend aneinandergepresst. Bei weicheren Tüchern war dies auch möglich, ohne die Qualität der polierten Halbleiterscheiben zu verschlechtern. Bei harten Poliertüchern ist jedoch z.B. ein weiches, kompressibles Filztuch als Zwischenlage erforderlich, um den Anforderungen an die Qualität der polierten Halbleiterscheiben zu genügen.

Bei der Verwendung von harten Tüchern ohne eine Zwischenlage war teilweise schon nach dem Pressvorgang erkennbar, dass die Tücher im inneren Bereich nicht ausreichend gepresst waren, die Tücher also keine ausreichende Haftung am Polierteller hatten.
Bei erfindungsgemäßer Verwendung einer Zwischenlage sind die Poliertücher dagegen nach dem Pressvorgang vollständig angepresst, so dass eine bessere und homogenere Haftung des Poliertuches erreicht wird, was zu einer besseren Qualität der polierten Halbleiterscheiben führt.

In einer Ausführungsform der Erfindung erfolgt vor dem beidseitigen Polieren einer Halbleiterscheibe zwischen den derart auf den Poliertellern befestigten Poliertüchern ein sog. Tuchdressing. Dabei werden die auf den Poliertellern aufgeklebten Poliertücher vor dem Poliervorgang an die jeweilige individuelle Tellerform der Poliermaschine angepasst. Entsprechende Methoden sind prinzipiell aus dem Stand der Technik bekannt und beispielsweise in den Schriften EP 2 345 505 A2 oder US 6,682,405 B2 beschrieben.

Das Tuchdressing ist vorteilhaft, da ein Polierteller üblicherweise Unterschiede in der lokalen Ebenheit von bis zu ± 50 µm aufweisen kann. Es dient dazu, durch mechanische Bearbeitung des sich auf dem Polierteller befindlichen Poliertuchs mittels geeigneten Werkzeugen, die in der Regel Diamantschleifkörper beinhalten, sowohl eine gewünschte Poliertuchgeometrie und damit eine gewünschte Polierspaltgeometrie, als auch die gewünschten Eigenschaften der Tuchoberfläche (Arbeitsfläche) des Poliertuchs einzustellen. Das auf dem Polierteller befindliche Poliertuch wird jeweils auf eine bestimmte Poliermaschine und einen Polierspalt hin optimiert.

In einer Ausführungsform erfolgt das Tuchdressing der beiden Poliertücher, also die Bearbeitung der Arbeitsflächen der Poliertücher, derart, dass ein Polierspalt, den die zu polierende Halbleiterscheibe jeweils mit der mit der Halbleiterscheibe in Kontakt kommenden Oberfläche des Poliertuchs bildet und der sich von einem inneren Rand bis zu einem äußeren Rand des Poliertuchs erstreckt, am inneren Rand und am äußeren Rand der Poliertuchs eine unterschiedliche Höhe aufweist. In anderen Worten weist das Poliertuch im Zentrum eine andere Tuchdicke auf als am äußeren Rand.

In einer Ausführungsform des Verfahrens ist die Höhe des Polierspaltes, also der jeweilige Abstand zwischen dem oberen und unteren Poliertuch, am äußeren Rand niedriger als am inneren Rand des Poliertuchs.

Zum Polieren werden die Halbleiterscheiben in eine geeignet dimensionierte Aussparung einer Läuferscheibe gelegt. Vorzugsweise wird in den zwischen den Arbeitsschichten der Poliertücher gebildeten Arbeitsspalt während der Politur eine Flüssigkeit zugeführt. Bei dieser Flüssigkeit handelt es sich vorzugsweise um eine Poliermittelsuspension. Besonders bevorzugt ist die Verwendung von kolloiddisperser Kieselsäure, ggf. mit Zusätzen wie z.B. Natriumcarbonat (Na2C03), Kaliumcarbonat (K2C03), Natriumhydroxid (NaOH), Kaliumhydroxid (KOH), Ammoniumhydroxid (NH40H), Tetramethylammoniumhydroxid (TMAH), als Poliermittelsuspension. Bei der gleichzeitigen Politur der Vorderseite und der Rückseite der Halbleiterscheibe erfolgt vorzugsweise ein Oberflächenabtrag von kleiner oder gleich 15 µm pro Seite, besonders bevorzugt 5 µm bis 12 µm pro Seite.

Diese und andere Merkmale der erfindungsgemäßen Ausführungsformen werden in den Ansprüchen erläutert.

Nachfolgend werden die Vorteile der Erfindung anhand von Vergleichsbeispielen und Beispielen erläutert.

Sofern nicht anders angegeben, wurden alle zuvor und in den folgenden Beispielen und Vergleichsbeispielen genannten Parameter bei einem Druck der umgebenden Atmosphäre, also bei etwa 1000 hPa, und bei einer relativen Luftfeuchte von 50% ermittelt.

Die Härte nach Shore A wird gemäß DIN EN ISO 868 ermittelt. Es kommt ein Durometer Typ A zum Einsatz (Härteprüfgerät Zwick 3130). Die Spitze der gehärteten Stahlstange drückt in das Material ein. Die Eindrücktiefe wird auf einer Skala von 0 - 100 gemessen. Der Stahl-Stift hat die Geometrie eines Kegelstumpfes. Es werden jeweils fünf Messungen vorgenommen, von denen der Medianwert angegeben ist. Die Messzeit beträgt 15 s, das zu prüfende Material wurde 1 h bei Normklima (23 °C, 50 % Luftfeuchte) gelagert. Das Andruckgewicht des Durometers beträgt 12,5 N ± 0,5.

### Vergleichsbeispiele

### Vergleichsbeispiel 1

Poliertücher aus Filz (PU) Härte 60 nach Shore A bei 23°C, Kompressibilität 9,4 % bei 23°C, Dicke 1,27 mm
Tuchpressen ohne Zwischenlage, Druck 11 000 Pa, 2 Stunden

Nach dem Tuchpressen zeigt sich eine gute Haftung der Poliertücher auf den Poliertellern.

### Vergleichsbeispiel 2

Poliertücher aus Filz (aus PU-Elastomer-Fasern) Härte 84 nach Shore A bei 23°C, Kompressibilität 2,6% bei 23°C, Dicke 1,27 mm
Tuchpressen ohne Zwischenlage, Druck 11 000 Pa, 2 Stunden

Nach dem Tuchpressen zeigt sich eine schlechte Haftung des inneren Bereiches der Poliertücher auf den Poliertellern. Dies würde unweigerlich zu Qualitätsmängeln bei der Politur der Halbleiterscheiben führen.

### Vergleichsbeispiel 3

Geschäumte Poliertücher (PU) Härte 93° Shore A bei 23°C, Kompressibilität 2,5% bei 23°C, Dicke 1,06 mm
Tuchpressen ohne Zwischenlage, Druck 11 000 Pa, 2 Stunden

Nach dem Tuchpressen zeigt sich eine schlechte Haftung des inneren Bereiches der Poliertücher auf den Poliertellern. Dies würde unweigerlich zu Qualitätsmängeln bei der Politur der Halbleiterscheiben führen.

### Beispiel 1

Poliertücher aus Filz (aus PU-Elastomer-Fasern) Härte 84 nach Shore A bei 23°C, Kompressibilität 2,6% bei 23°C, Dicke 1,27 mm
Verwendung einer Zwischenlage beim Tuchpressen (Druck 11 000 Pa, 2 Stunden) Zwischenlage: doppellagiger PU-Filz, Dicke einer Lage 1,27 mm, Kompressibilität 3,3% bei 23°C, Härte 83 nach Shore A bei 23°C
Nach dem Tuchpressen zeigt sich eine hervorragende Haftung der Poliertücher auf den Poliertellern.

### Beispiel 2

Geschäumte Poliertücher (PU) Härte 84 nach Shore A bei 23°C, Kompressibilität 2,1% bei 23°C. Dicke 0,86 mm
Verwendung einer Zwischenlage beim Tuchpressen (Druck 11 000 Pa, 2 Stunden) Zwischenlage: doppellagiger PU-Filz, Dicke einer Lage 1,27 mm, Kompressibilität 3,3% bei 23°C, Härte 83 nach Shore A bei 23°C
Nach dem Tuchpressen zeigt sich eine hervorragende Haftung der Poliertücher auf den Poliertellern.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren innerhalb des Schutzbereiches der durch die Ansprüche definiert wird.

## Patentansprüche

1. Verfahren zum beidseitigen Polieren einer Halbleiterscheibe, wobei auf oberem und unterem Polierteller Poliertücher einer Härte bei Raumtemperatur von mindestens 80° nach Shore A und mit einer Kompressibilität bei Raumtemperatur von weniger als 3 % befestigt werden, wobei eine Halbleiterscheibe zwischen oberem und unterem Poliertuch beidseitig poliert wird, wobei zum Befestigen der Poliertücher auf oberem und unterem Polierteller die Poliertücher auf den oberen und den unteren Polierteller geklebt werden, **dadurch gekennzeichnet, dass** zwischen den beiden aufgeklebten Poliertüchern als Zwischenlage ein Tuch mit einer Kompressibilität bei Raumtemperatur von mindestens 3 % positioniert wird und anschließend die beiden Poliertücher mit dem zwischen ihnen befindlichen Tuch für einen bestimmten Zeitraum aneinander gepresst werden.

2. Verfahren nach Anspruch 1, wobei es sich bei den Poliertüchern um geschäumte Tücher auf der Basis von PU handelt.

3. Verfahren nach Anspruch 1 oder nach Anspruch 2, wobei die Poliertücher eine Härte bei Raumtemperatur von 80 bis 100° nach Shore A aufweisen.

4. Verfahren nach einem der Ansprüche 1 bis 3, wobei die Kompressibilität des Poliertuches bei Raumtemperatur weniger als 2,5% beträgt.

5. Verfahren nach einem der Ansprüche 1 bis 4, wobei das als Zwischenlage verwendete Tuch bei Raumtemperatur eine Kompressibilität von 3,2-7,6% aufweist.

6. Verfahren nach einem der Ansprüche 1 bis 5, wobei es sich bei dem als Zwischenlage verwendeten Tuch um Filz oder um ein Fasersubstrat handelt.

7. Verfahren nach Anspruch 6, wobei das als Zwischenlage verwendete Tuch auf PU-Elastomer-Fasern basiert.

8. Verfahren nach einem der Ansprüche 1 bis 7, wobei das als Zwischenlage verwendete Tuch zwei zusammen geklebte Tücher umfasst.

9. Verfahren nach einem der Ansprüche 1 bis 8, wobei eine Dicke der Poliertücher 0,75 bis 1,1 mm beträgt.

10. Verfahren nach einem der Ansprüche 1 bis 9, wobei eine Dicke des als Zwischenlage verwendeten Tuchs 1,5 bis 2,6 mm beträgt.

## Claims

1. A method for polishing a semiconductor wafer on both sides, polishing pads of a Shore A hardness at room temperature of at least 80 and having a compressibility at room temperature of less than 3% being attached to upper and lower polishing plates, a semiconductor wafer being polished on both sides between upper and lower polishing pads, wherein the polishing pads are attached to the upper and lower polishing plate by bonding the polishing pads to the upper and lower polishing plate, by positioning a pad having a compressibility at room temperature of at least 3% between the two bonded polishing pads as intermediate layer and by then pressing together the two polishing pads with the pad situated therebetween for a certain period of time.

2. The method as claimed in claim 1, wherein the polishing pads are foamed pads based on PU.

3. The method as claimed in claim 1 or as claimed in claim 2, wherein the polishing pads have a Shore A hardness at room temperature of from 80 to 100.

4. The method as claimed in any of claims 1 to 3, wherein the compressibility of the polishing pad at room temperature is less than 2.5%.

5. The method as claimed in any of claims 1 to 4, wherein the pad used as intermediate layer has a compressibility of 3.2-7.6% at room temperature.

6. The method as claimed in any of claims 1 to 5, wherein the pad used as intermediate layer is felt or a fibrous substrate.

7. The method as claimed in claim 6, wherein the pad used as intermediate layer is based on PU elastomer fibers.

8. The method as claimed in any of claims 1 to 7, wherein the pad used as intermediate layer comprises two pads bonded together.

9. The method as claimed in any of claims 1 to 8, wherein a thickness of the polishing pads is from 0.75 to 1.1 mm.

10. The method as claimed in any of claims 1 to 9, wherein a thickness of the pad used as intermediate layer is from 1.5 to 2.6 mm.

## Revendications

1. Méthode de polissage d'une plaquette semi-conductrice sur les deux faces, des toiles de polissage ayant une dureté à température ambiante d'au moins 80° selon Shore A et une compressibilité à température ambiante inférieure à 3 % étant fixées sur la plaque de polissage supérieure et inférieure, une plaquette semi-conductrice étant polie sur les deux faces entre la toile de polissage supérieure et inférieure, **caractérisé en ce que** les toiles de polissage ont une dureté à température ambiante d'au moins 80° selon Shore A et une compressibilité à température ambiante inférieure à 3 %, **en ce que**, pour fixer les draps de polissage sur les disques de polissage supérieur et inférieur, les draps de polissage sont collés sur les disques de polissage supérieur et inférieur, un tissu ayant une compressibilité à température ambiante d'au moins 3 % est placé entre les deux draps de polissage collés comme couche intermédiaire, et les deux draps de polissage sont ensuite pressés l'un contre l'autre avec le tissu situé entre eux pendant une durée déterminée.

2. Méthode selon la revendication 1, dans lequel les chiffons de polissage sont des chiffons en mousse à base de PU.

3. Méthode selon la revendication 1 ou selon la revendication 2, dans lequel les chiffons de polissage ont une dureté Shore A à température ambiante de 80 à 100°.

4. Méthode selon l'une des revendications 1 à 3, dans laquelle la compressibilité du chiffon de polissage à température ambiante est inférieure à 2,5%.

5. Méthode selon l'une quelconque des revendications 1 à 4, dans laquelle le tissu utilisé comme couche intermédiaire a une compressibilité de 3,2 à 7,6 % à température ambiante.

6. Méthode selon l'une des revendications 1 à 5, dans laquelle le tissu utilisé comme couche intermédiaire est du feutre ou un substrat fibreux.

7. Méthode selon la revendication 6, dans lequel le tissu utilisé comme couche intermédiaire est à base de fibres d'élastomère PU.

8. Méthode selon l'une des revendications 1 à 7, dans laquelle le tissu utilisé comme couche intermédiaire est constitué de deux tissus collés ensemble.

9. Méthode selon l'une des revendications 1 à 8, dans laquelle l'épaisseur des chiffons de polissage est de 0,75 à 1,1 mm.

10. Méthode selon l'une des revendications 1 à 9, dans laquelle l'épaisseur du tissu utilisé comme couche intermédiaire est de 1,5 à 2,6 mm.
